(19) Europäisches Patentamt
European Patent Office
Office européen des brevets

(11) **EP 3 012 643 B1**

(12) **EUROPEAN PATENT SPECIFICATION**

(45) Date of publication and mention
of the grant of the patent:
**30.09.2020   Bulletin 2020/40**

(51) Int Cl.:
***G01R 31/08*** (2020.01)

(21) Application number: **14897888.5**

(22) Date of filing: **13.08.2014**

(86) International application number:
**PCT/CN2014/084248**

(87) International publication number:
**WO 2016/019593 (11.02.2016 Gazette 2016/06)**

(54) **METHOD AND APPARATUS FOR IDENTIFYING CAUSES FOR CABLE OVERCURRENT**

VERFAHREN UND VORRICHTUNG ZUR IDENTIFIKATION DER URSACHEN VON ÜBERSTROM IN EINEM KABEL

PROCÉDÉ ET APPAREIL D'IDENTIFICATION DE CAUSES DE SURINTENSITÉ DE CÂBLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.08.2014   CN 201410383429**

(43) Date of publication of application:
**27.04.2016   Bulletin 2016/17**

(73) Proprietors:
• **Zhejiang Truly Electric Co. Ltd.**
  **Hangzhou, Zhejiang 311100 (CN)**
• **State Grid Corporation of China (SGCC)**
  **Beijing 100031 (CN)**
• **State Grid Zhejiang Hangzhou Yuhang Power Supply**
  **Company**
  **LinPing, YuHang**
  **Hangzhou, Zhejiang 311100 (CN)**
• **Hangzhou Power Supply Company of State Grid Zhejiang Electric Power Company**
  **Hangzhou, Zhejiang 310000 (CN)**
• **State Grid Zhejiang Electric Power Company**
  **Zhejiang 310007 (CN)**

(72) Inventors:
• **LIU, Lifeng**
  **Hangzhou, Zhejiang 311100 (CN)**
• **ZHANG, Jing**
  **Hangzhou, Zhejiang 311100 (CN)**
• **LI, Tiyin**
  **Hangzhou, Zhejiang 311100 (CN)**
• **LIU, Yi**
  **Hangzhou, Zhejiang 311100 (CN)**

• **YAO, Haiyan**
  **Hangzhou, Zhejiang 311100 (CN)**
• **XU, Chao**
  **Hangzhou, Zhejiang 311100 (CN)**
• **TU, Yongwei**
  **Hangzhou, Zhejiang 311100 (CN)**

(74) Representative: **HGF**
**1 City Walk**
**Leeds LS11 9DX (GB)**

(56) References cited:
**CN-A- 101 907 437      CN-A- 102 253 327
CN-A- 102 567 783      CN-A- 102 570 392
CN-A- 103 713 237      CN-K1- 102 721 889
CN-K1- 103 713 237**

• **DASH P K ET AL: "Fault Classification and Section Identification of an Advanced Series-Compensated Transmission Line Using Support Vector Machine", IEEE TRANSACTIONS ON POWER DELIVERY, IEEE SERVICE CENTER, NEW YORK, NY, US, vol. 22, no. 1, 1 January 2007 (2007-01-01), pages 67-73, XP011152563, ISSN: 0885-8977, DOI: 10.1109/TPWRD.2006.876695**
• **SUNDARAVARADAN N A ET AL: "Wavelet based transmission line fault analysis: A literature survey", 2014 14TH INTERNATIONAL CONFERENCE ON ENVIRONMENT AND ELECTRICAL ENGINEERING, IEEE, 10 May 2014 (2014-05-10), pages 254-259, XP032607625, DOI: 10.1109/EEEIC.2014.6835874 [retrieved on 2014-06-16]**

**Description**

This application claims priority to Chinese patent application No. 201410383429.3, titled "METHOD AND DEVICE FOR IDENTIFYING CABLE OVERCURRENT CAUSES" filed on August 6, 2014 with the State Intellectual Property Office of the People's Republic of China.

**FIELD**

The present disclosure relates to the field of electrical system, and in particular to a method for identifying a reason for an overcurrent in an electric cable and a device for the same.

**BACKGROUND**

With an increasing development of urbanization construction, electric power cables are tend to be used for power transmission in an urban power distribution system. Since the electric power cables are generally buried in soil, laid indoor, or in a channel or tunnel, an insulation distance between the cables is short and the electric power cables substantially occupy no space or only occupy a few space on ground due to no use of a tower, the electric power cables are electric-shocked in little possibility and are little affected by a climate condition and surroundings. Therefore, the electric power cables have a high transmission performance and a high reliability, and are more reliable and secure for power supply. However, a flashover, a partial discharge and the like occurring on the electric power cables may cause a permanent failure of the electric power cables, which is difficult to be detected.

An incipient failure of the electric power cable is generally caused by inner aging of an insulation layer, and generally appears as a short-time single-phase overcurrent, of which the duration ranges from 0.5 cycles to 5 cycles. If the incipient failure cannot be detected, recognized and further restored or replaced instantly and effectively, it may become a permanent failure. Therefore, a pre-alarm for the incipient failure of the electric power cable is performed, the number of serious failures can be reduced effectively, losses due to power failures caused by failures of the electric power cable are reduced, a secure operation capability of the electric grid is improved, and the service lives of lines of the electric grid are prolonged.

At present, the incipient failure of the electric power cable is mainly detected by detecting whether a short-time overcurrent occurs in the electric cable. However, even if a short-time single-phase overcurrent signal can be detected in the above way, the result of the above detection cannot accurately represent that the incipient failure of the electric cable is detected. This is because there are many reasons for the single-phase short-time overcurrent, such as putting a voltage transformer and a capacitor into operation, a load inputting and a starting of an electric motor. Therefore, an accurate reason for a short-time single-phase overcurrent signal cannot be determined with the above method. At present, in the detection of the incipient failure of the electric cable, only a short-time single-phase overcurrent signal is detected, but it is further identified whether the overcurrent is caused by the incipient failure of the electric cable.

Therefore, how to find a reason for a current single-phase overcurrent from multiple reasons for the short-time overcurrent is an issue to be addressed by those skilled in the art.

Document "Fault Classification and Section Identification of an Advanced Series-Compensated Transmission Line Using Support Vector Machine" (Dash et al. IEEE Transactions on Power Delivery, IEEE Service Center, vol. 22, no.1, pages 67-73, 1 January 2007) discloses for distance protection of flexible as transmission lines, including thyristor-controlled series compensator, static synchronous compensator and static var compensator, a method using postfault current samples for half cycle from the inception of the fault and firing angle as inputs to the SVM is proposed. The SVMs are trained with polynomial kerel and Gaussian kernel with different parameter values to get the most optimized classifier. Document CN 102721889 discloses a cable fault detection method for early re wavelet singularity detection, including acquiring a current signal of a cable to be detected in a power distribution network, and performing N-layer discrete wavelet transform on the current signal by using complex wavelets to obtain a wavelet transform coefficient on each decomposition level; and extracting amplitude information of a wavelet coefficient on each decomposition level, tracking the modulus maximum of the wavelet coefficient on each decomposition level, and recording a point on which the modulus maximum occurs in each decomposition level, wherein the corresponding occurrence moment of a first recorded modulus maximum point is the occurrence moment of an early fault, and the corresponding occurrence moment of a last recorded modulus maximum point is the ending moment of the early fault. According to the method, the early fault of the cable can be detected effectively, so that a defective cable can be pre-warned; and measures are adopted before the occurrence of the fault, and therefore losses caused by a permanent fault are reduced greatly, the running safety of a power grid is enhanced, and the running service life of the cable is prolonged.

Document "Wavelet based transmission line fault analysis: A literature survey" (Sundaravaradan et al. 2014 14th International Conference on Environment and Electrical Engineering, IEEE, 10 May 2014, pages 254-259) presents implementation of discrete wavelet transform, multi-resolution analysis artificial neural networks and fuzzy logic for fault

**EP 3 012 643 B1**

analysis. Document CN 103713237 discloses a novel power system electric transmission line fault diagnosis method. The method includes the steps that first, fault recording wave signals of an electric transmission line are extracted, and a three-phase current value and a discrete value of an earth current of the electric transmission line are obtained through discrete wavelet transform; then, according to a wavelet function db10, the wavelet coefficient entropy of each phase current is calculated, the sum of the wavelet coefficient absolute entropy of all the phase currents is calculated, and the largest value phase, the smallest value phase and the medium value phase of the three values are determined through comparison. According to the designed algorithm, the type and the phase of a fault which happens to a circuit where input current signals are located are judged. The algorithm relates to three parameters, and the parameters are set through a training set; model accuracy verification is performed through a test set, and meanwhile the parameters are corrected. With the method, whether a fault happens to the circuit and the type of the fault can be fast judged, and therefore good assistance effect is played for on-site dispatch personnel to fast and accurately position a fault area after the fault happens, and the security and the stability of the electric transmission line can be improved easily.

**SUMMARY**

An object of the present invention is to provide a method for identifying a reason for an overcurrent in an electric cable, with which a reason for a current single-phase overcurrent in the electric cable can be identified. The other object of the present disclosure is to provide a device for identifying a reason for an overcurrent in an electric cable.

To address the above issue, the following technical solutions are provided according to embodiments of the present disclosure.

A method for identifying a reason for an overcurrent in an electric cable is provided, which includes:

step 1), detecting whether a single-phase overcurrent occurs in three-phase current signals;

step 2), determining an indicator feature vector sample of an overcurrent phase current signal in a case that it is detected that the single-phase overcurrent occurs in the three-phase current signals;

step 3), calculating association coefficients between the indicator feature vector sample and predetermined indicator vector reference samples of indicators, where the indicator vector reference samples respectively correspond to reasons for the single-phase overcurrent;

step 4), calculating association degrees between the indicator feature vector sample and the predetermined indicator vector reference samples based on a predetermined indicator weight vector and the association coefficients corresponding to the indicators; and

step 5), finding a reason for the single-phase overcurrent reason, which corresponds to an indicator vector reference sample having a maximal association degree,

where the determining the indicator feature vector sample of the overcurrent phase current signal in the three-phase current signals includes: performing a wavelet transform on the three-phase current signals in the electric cable by using a db4 wavelet; performing a five-layer discomposing on the transformed three-phase current signals to obtain five layers of high-frequency detail coefficients, one layer of low-frequency approximate coefficient, the sum of energy values of the layers of detail coefficients, an effective value of the overcurrent phase current and a duration of the overcurrent; and determining thereby nine indicators as the indicator feature vector sample.

The detecting whether the single-phase overcurrent occurs in the three-phase current signals includes: performing a wavelet transform on the three-phase current signals in the electric cable; calculating wavelet transform modulus maxima for the phase currents; detecting whether a wavelet transform modulus maximum of only one phase current jumps successively twice in a range from 0.5 cycles to 5 cycles; and determining that a short-time overcurrent occurs in the one phase current in a case that it is detected that the wavelet transform modulus maximum of the only one phase current jumps successively twice in the range from 0.5 cycles to 5 cycles.

The sum of the energy values of the layers of detail coefficients is calculated by using a formula of:

$$E_d = \sum_{j=1}^{5}\sum_{n=1}^{N} d_j^2$$

, where Ed is the sum of the energy values of the layers of detail coefficients, and dj is a detail coefficient of a j-th layer.

The association degrees are calculated by using a formula of:

$$\gamma_k = \sum_{l=1}^{s} \omega_x^{(l)} \xi_k^{(l)},$$

where $\gamma_k$ is an association degree between the indicator feature vector sample and a k-th indicator vector reference

3

sample, $\omega_x^{(l)}$ is a weight coefficient of an *l*-th indicator, $\xi_k^{(l)}$ is an association coefficient between the indicator feature vector sample and the *l*-th indicator in the *k*-th indicator vector reference sample, and s is the number of the indicators.

A device for identifying a reason for an overcurrent in an electric cable is further provided according to an embodiment of the present disclosure, which includes:

a three-phase current processing unit, configured to detect whether a single-phase overcurrent occurs in three-phase current signals;

an indicator feature vector sample determination unit, configured to determine an indicator feature vector sample of an overcurrent phase current signal in a case that it is

detected that the single-phase overcurrent occurs in the three-phase current signals;

a first calculation unit, configured to calculate association coefficients between the indicator feature vector sample and predetermined indicator vector reference samples of indicators, where the indicator vector reference samples respectively correspond to reasons for the single-phase overcurrent;

a second calculation unit, configure to calculate association degrees between the indicator feature vector sample and the predetermined indicator vector reference samples based on an indicator weight vector and the association coefficients corresponding to the indicators; and

a discrimination unit, configured to find a reason for the single-phase overcurrent, which corresponds to an indicator vector reference sample having a maximal association degree,

where the indicator feature vector sample determination unit includes: a coefficient determination sub-unit, configured to perform a wavelet transform on the three-phase current signals in the electric cable by using a db4 wavelet and perform a five-layer discomposing on the transformed three-phase current signals to obtain five layers of high-frequency detail coefficients, one layer of low-frequency approximate coefficient, the sum of energy values of the layers of detail coefficients, an effective value of the overcurrent phase current and a duration of the overcurrent, and determine thereby nine indicators as the indicator feature vector sample.

The three-phase current processing unit includes: a wavelet transformer and a discriminator,

where the wavelet transformer is configured to perform a wavelet transform on the three-phase current signals in the electric cable and calculate wavelet transform modulus maxima for the phase currents; and

the discriminator is configured to detect whether a wavelet transform modulus maximum of only one phase current jumps successively twice in a range from 0.5 cycles to 5 cycles, and determine that a short-time overcurrent occurs in the one phase current in a case that it is detected that the wavelet transform modulus maximum of the one phase current jumps successively twice in the range from 0.5 cycles to 5 cycles.

The coefficient determination sub-unit includes:

an energy value calculation sub-unit, configured to calculate the sum of the energy values of the layers of detail coefficients

$$E_d = \sum_{j=1}^{5} \sum_{n=1}^{N} d_j^2$$

based on a formula of: , where $E_d$ is the sum of the energy values of the layers of detail coefficients, and $d_j$ is a detail coefficient of a j-th layer.

The second calculation unit includes:

a second calculation execution sub-unit, configured to calculate the association degrees based on a formula of:

$$\gamma_k = \sum_{l=1}^{s} \omega_x^{(l)} \xi_k^{(l)}$$

, where $\gamma_k$ is an association degree between the indicator feature vector sample and a *k*-th indicator

vector reference sample, $\omega_x^{(l)}$ is a weight coefficient of an *l*-th indicator, $\xi_k^{(l)}$ is an association coefficient between the indicator feature vector sample and the *l*-th indicator in the *k*-th indicator vector reference sample, and s is the number of the indicators.

Based on the above technical solutions, in the method for identifying the reason for the overcurrent in the electric cable, it is detected whether a single-phase overcurrent occurs in three-phase current signals; an indicator feature vector sample of the overcurrent phase current signal is determined in a case that it is detected that the single-phase overcurrent occurs in the three-phase current signals; association coefficients between the indicator feature vector sample and predetermined indicator vector reference samples of indicators are calculated, and the indicator vector reference samples respectively correspond to reasons for the single-phase overcurrent; association degrees between the indicator feature vector sample and the predetermined indicator vector reference samples are calculated based on an indicator weight vector and the association coefficients corresponding to the indicators; and a reason for the single-phase overcurrent is found, which corresponds to an indicator vector reference sample having a maximal association degree value. Therefore, an accurate reason for the current single-phase overcurrent in the electric cable is determined, and it can also be determined which single-phase overcurrent in the electric cable is caused by an incipient failure, and thus the incipient failure of the electric cable can be discriminated accurately. In this case, a reasonable measure may be taken to restore or replace the electric cable, the number of serious failures can be reduced effectively, losses due to power failures caused by failures of electric power cables are reduced, a secure operation capability of an electric grid is improved and the service lives of lines of the electric grid are prolonged.

**BRIEF DESCRIPTION OF THE DRAWINGS**

Figure 1 is a flowchart of a method for identifying a reason for an overcurrent in an electric cable according to an embodiment of the present disclosure;

Figure 2 is a flowchart of a method for detecting whether a single-phase overcurrent occurs in three-phase current signals according to an embodiment of the present disclosure;

Figure 3 is a block diagram of a device for identifying a reason for an overcurrent in an electric cable according to an embodiment of the present disclosure;

Figure 4 is a block diagram of a three-phase current processing unit according to an embodiment of the present disclosure;

Figure 5 is a block diagram of an indicator feature vector sample determination unit according to an embodiment of the present disclosure;

Figure 6 is a block diagram of a coefficient determination sub-unit according to an embodiment of the present disclosure;

Figure 7 is a block diagram of a first calculation unit according to an embodiment of the present disclosure;

Figure 8 is a block diagram of a second calculation unit according to an embodiment of the present disclosure; and

Figure 9 is a block diagram of a discrimination unit according to an embodiment of the present disclosure.

**DETAILED DESCRIPTION**

An object of the present disclosure is to provide a method for identifying a reason for an overcurrent in an electric cable, with which a reason for a current single-phase overcurrent in the electric cable can be identified. The other object of the present disclosure is to provide a device for identifying a reason for an overcurrent in an electric cable.
In order that the objects, technical solutions and advantages according to embodiments of the present disclosure can be clearer, the technical solutions according to the embodiments of the present disclosure are described clearly and completely as follows in conjunction with the drawings. It is obvious that the described embodiments are only a few rather than all of the embodiments according to the present disclosure. Any other embodiments obtained by those skilled in the art based on the embodiments in the present disclosure without any creative work fall in the scope of the present disclosure.

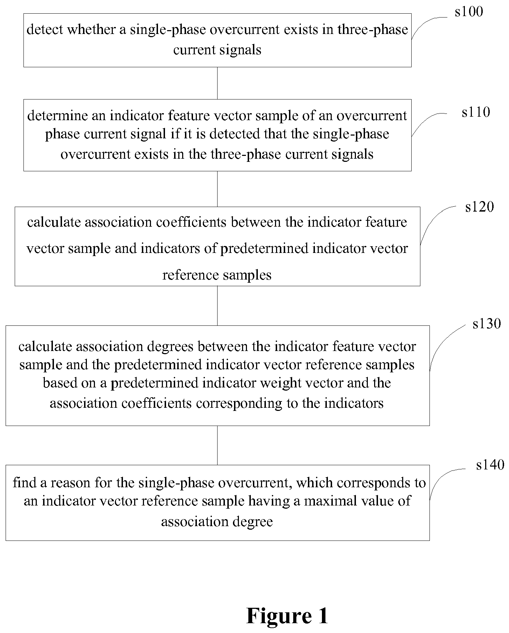

Figure 1 is a flowchart of a method for identifying a reason for an overcurrent in an electric cable according to an embodiment of the present disclosure. The method may include the following steps s100 to s140.
In step s100, it is detected whether a single-phase overcurrent occurs in three-phase current signals.
In this step, sampling is performed on the three-phase current signals in the electric cable, and the three-phase current signals in one sample window are respectively transformed to judge whether a single-phase overcurrent occurs in only one of the three-phase current signals. If the single-phase overcurrent occurs in only one of the three-phase current signals, a next step is performed. Or, the three-phase current signals in the one sampling window are transformed respectively if the single-phase overcurrent does not occur or occurs in more than one phase current signal.
In step s110, an indicator feature vector sample of an overcurrent phase current signal is determined in a case that it is detected that the single-phase overcurrent occurs in the three-phase current signals.
In a case that it is detected that the single-phase overcurrent occurs in the three-phase current signals, desired indicator feature values obtained during the transformations are recorded and calculated, and the indicator feature vector sample of the overcurrent phase current signal is formed in the order of the indicators in the indicator vector reference sample.

In step s120, association coefficients between the indicator feature vector sample and predetermined indicator vector reference samples of indicators are calculated, and the indicator vector reference samples respectively correspond to reasons for the single-phase overcurrent.

The indicator vector reference sample includes reference values of the indicators, which are formed based on a large amount of measured data and empirical data, in a case that a single-phase overcurrent occurs due to an incipient failure of the electric cable, putting a voltage transformer into operation, putting a capacitor into operation, a load inputting, an electrical motor starting, and the like. The indicator vector reference sample is composed of the reference values of the indicators.

The association coefficients between the indicator feature vector sample and predetermined indicator vector reference samples due to the reasons are calculated. Of course, the indictor vector reference samples respectively correspond to reasons for the single-phase overcurrent.

In step s130, association degrees between the indicator feature vector sample and the predetermined indicator vector reference samples are calculated based on an indicator weight vector and the association coefficients corresponding to the indicators.

The predetermined indicator weight vector sample is formed based on weights of the indicators in the reasons for the single-phase overcurrent in the electric cable, which is obtained by expert scoring based on a large amount of measured data and empirical data.

The association degrees between the obtained association coefficients and the predetermined indicator weight vector sample are calculated.

In step s140, a reason for the single-phase overcurrent is found, which corresponds to an indicator vector reference sample having a maximal association degree value.

For the obtained association degree values, a maximal value is found and an association coefficient corresponding to the maximal value is also found; and then an indicator vector reference sample is found, where the association coefficient is obtained based on the indicator vector reference sample and the indicator feature vector sample. Since the indicator vector reference samples respectively correspond to the reasons for the single-phase overcurrent in the electric cable, the reason for the current single-phase overcurrent in the electric cable is found.

In the method for identifying the reason for the overcurrent in the electric cable according to the embodiment of the present disclosure, it is detected whether a single-phase overcurrent occurs in three-phase current signals; an indicator feature vector sample of the overcurrent phase current signal is determined in a case that it is detected that the single-phase overcurrent occurs in the three-phase current signals; association coefficients between the indicator feature vector sample and predetermined indicator vector reference samples of indicators are calculated, and the indicator vector reference samples respectively correspond to reasons for the single-phase overcurrent; association degrees between the indicator feature vector sample and the predetermined indicator vector reference samples are calculated based on an indicator weight vector and the association coefficients corresponding to the indicators; and a reason for the single-phase overcurrent is found, which corresponds to an indicator vector reference sample having a maximal association degree value. Therefore, an accurate reason for the current single-phase overcurrent in the electric cable is determined, and it can also be determined which single-phase overcurrent in the electric cable is caused by an incipient failure, and thus the incipient failure of the electric cable can be discriminated accurately. In this case, a reasonable measure may be taken to restore or replace the electric cable, the number of serious failures can be reduced effectively, losses due to power failures caused by failures of power cables are reduced, a secure operation capability of an electric grid is improved and the service lives of lines of the electric grid are prolonged.

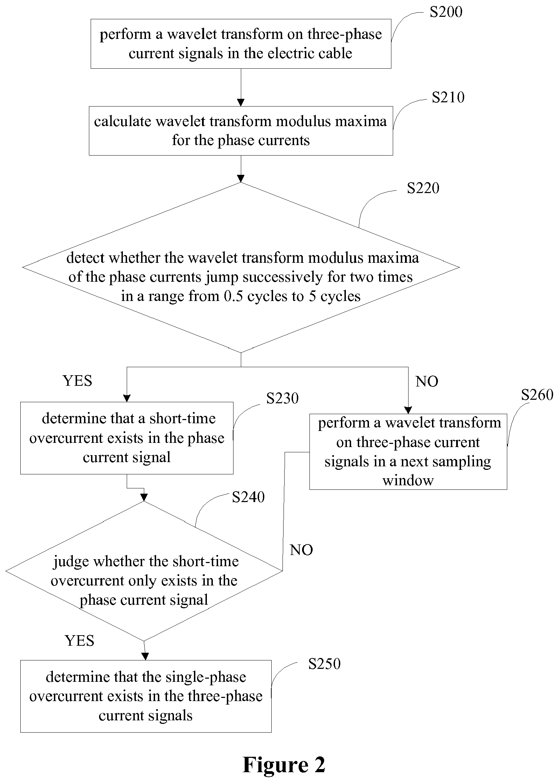

Optionally, Figure 2 is a flowchart of a method for detecting whether a single-phase overcurrent occurs in three-phase current signals according to an embodiment of the present disclosure. Referring to Figure 2, the method for detecting whether the single-phase overcurrent occurs in the three-phase current signals may include the following steps s200 to s260.

In step s200, a wavelet transform is performed on the three-phase current signals in the electric cable.

Optionally, the wavelet transform may be performed on the three-phase current signals in the electric cable by using a db4 wavelet in a 5-layer discomposing way. That is, the db4 wavelet and 5-layer discomposing are selected to perform the wavelet transform on the three-phase current signals in each sampling window.

In step s210, wavelet transform modulus maxima for the phase currents are calculated.

Optionally, in a case of defining a wavelet transform modulus maximum of a signal, the wavelet transform is in a convolution form for a filtering effect. If a scale is at $a_0$, a convolution-formed wavelet transform of a current signal $i(t)$ is $WTi(a_0, t)$.

If the following condition is met in the field of $t_0$:

$$|WTi(a_0,\ t)| \leqslant |WTi(a_0,\ t_0)| \qquad\qquad (1),$$

then $WTi(a_0,\ t_0)$ is referred to as a wavelet transform partial modulus maximum of $i(t)$ in a neighborhood of $t_0$ in a case of the scale $a_0$.

If $\dfrac{\partial WTi(a_0,t)}{\partial t}$ has an over maximum in a case that $t=t_0$, then $(a_0,\ t_0)$ is considered as a wavelet transform modulus-maximum point of the current signal $i(t)$.

In step s220, it is detected whether the wavelet transform modulus maxima of each of the phase currents jumps successively twice in a range from 0.5 cycles to 5 cycles. Step s230 is performed if the wavelet transform modulus maxima of the phase current jumps successively twice in a range from 0.5 cycles to 5 cycles; or step s260 is performed if the wavelet transform modulus maxima of the phase currents do not jump successively twice in a range from 0.5 cycles to 5 cycles.

Optionally, wavelet transforms are respectively performed on the three-phase current signals by using the db4 wavelet and 5-layer discomposing, to detect whether an overcurrent occurs in the phases. An incipient failure of the electric cable is generally a single-phase grounded failure and an overcurrent caused by the failure generally lasts for only 0.5 cycles to 5 cycles. Therefore, a second jump of a certain phase current signal is detected in a range of 0.5 cycles to 5 cycles after a first jump of the phase current signal is detected.

Optionally, the jump may be calculated as follows.

It is assumed that a function $\theta(t)$ meets a basic property of a wavelet function, that is,

$$\int_{-\infty}^{+\infty} \theta(t)dt = 1 \quad \text{and} \quad \lim_{x\to\infty}\theta(t) = 0 \qquad\qquad (2),$$

where $\theta(t)$ is a filter function with low-pass smoothing. If $\theta(t)$ is second-order derivable, and a first-order derivative and a second-order derivative are $\zeta(t)$ and $\eta(t)$ respectively. According to a derivation property of Fourier transform, $\zeta(t)$ and $\eta(t)$ still meet an admissible condition, that is, $\zeta(t)$ and $\eta(t)$ can serve as wavelet generating functions. The following equations are obtained respectively after wavelet transforms are performed on $i(t)$ using $\zeta(t)$ and $\eta(t)$:

$$WTi_\xi(a,t) = \frac{1}{a}\int_{-\infty}^{+\infty} i(\tau)\xi(\frac{t-\tau}{a})d\tau = a\frac{d}{dt}\big[i(t) * \theta_a(t)\big] \qquad\qquad (3)$$

$$WTi_\eta(a,t) = \frac{1}{a}\int_{-\infty}^{+\infty} i(\tau)\eta(\frac{t-\tau}{a})d\tau = a^2\frac{d^2}{dt^2}\big[i(t) * \theta_a(t)\big] \qquad\qquad (4)$$

It can be seen from the equations (3) and (4) that, $WTi\zeta(a,\ t)$ may be obtained by performing a convolution wavelet transform on $i(t)$ and $\theta a(t)$ and then calculating a first-order derivative on the result of the wavelet transform. $WTi\eta(a,\ t)$ is obtained by performing a convolution wavelet transform on $i(t)$ and $\theta a(t)$ and then calculating a second-order derivative on the result of the wavelet transform. A jump point of the current signal in the time domain corresponds to a maximum point of $WTi\zeta(a,\ t)$ after the wavelet transform, and a point where the maximum of $WTi\zeta(a,\ t)$ is obtained corresponds to a zero crossing point of $WTi\eta(a,\ t)$ according to the property of derivative. Therefore, the jump point of the current signal may be detected by using the maximum point of $WTi\eta(a,\ t)$ and the zero crossing point of $WTi\eta(a,\ t)$. A next step is performed in a case that the wavelet transform modulus maxima of the phase current jumps successively twice in a range from 0.5 cycles to 5 cycles; or a wavelet transform is performed on three-phase current signals in a next sampling window in a case that the wavelet transform modulus maxima of the phase currents do not jump successively twice in a range from 0.5 cycles to 5 cycles.

In step s230, it is determined that a short-time overcurrent occurs in the phase current signal.

The short-time overcurrent occurs in the phase current signal if the wavelet transform modulus maximum of the phase current jumps successively twice in a range from 0.5 cycles to 5 cycles.

In step s240, it is judged whether the short-time overcurrent only occurs in the phase current signal. Step 250 is performed if the short-time overcurrent only occurs in the phase current signal, or step 260 is performed if the short-time overcurrent does not only occur in the phase current signal.

In step s250, it is determined that the single-phase overcurrent occurs in the three-phase current signals.

In step s260, a wavelet transform is performed on the three-phase current signals in the next sampling window.

Optionally, the indicator feature vector sample and indicators in the indicator vector reference samples may be composed of five layers of high frequency detail coefficients, one layer of low frequency approximate coefficient, the sum of energy values of the high frequency detail coefficients, a duration of the overcurrent and an effective value of the overcurrent phase current, which are obtained after a wavelet signal is discomposed.

Optionally, the indicator feature vector sample may be calculated as follows.

With the above wavelet transform, the five layers of high frequency detail coefficients $[d_1, d_2, d_3, d_4, d_5]$, one layer of low frequency approximate coefficient $c_1$ and the sum of energy values of the high frequency detail coefficients $E_d$ are calculated, which are obtained after an overcurrent phase wavelet signal is discomposed. A feature vector, $X_1 = [x_1(1), x_1(2), ..., x_1(s)] = [d_1, d_2, d_3, d_4, d_5, c_1, E_d, T, I_\beta]$, of an indicator for identifying an incipient failure of an electric cable is composed of the five layers of high frequency detail coefficients $[d_1, d_2, d_3, d_4, d_5]$, one layer of low frequency approximate coefficient $c_1$, the sum of energy values of the high frequency detail coefficients $E_d$, a duration $T$ of the overcurrent and an effective value $I_\beta$ of the overcurrent phase current, where s is the number of the indicators. Contributions of the indicators to overcurrent identification are different. A predetermined indicator weight vector sample is an indicator weight vector $\omega_x$ composed of weights of the indicators in the overcurrent identification, which are weights of the indicators in reasons for the single-phase overcurrent in the electric cable obtained by analyzing a large amount of measured data and empirical data.

It can be known from a wavelet transform discomposing principle that, a detail coefficient $d_j$ and an approximate coefficient $c_j$ which are obtained by discomposing a signal of a j-th layer are respectively represented as ($j$=1, 2, ..., 5 herein):

$$d_j = \sum_i g_{i-2n} c_{j-1,i}$$
$$c_j = \sum_i h_{i-2n} c_{j-1,i}$$

$$(5),$$

where $g$ is a low-pass filter and $h$ is a high-pass filter. The above equation represents that, the detail coefficient of a j-th scale may be obtained by performing a convolution on an approximate coefficient of a (j-1)-th scale and the low-pass filter and then down-sampling by two the convolution results; and the approximate coefficient of a j-th scale may be obtained by performing a convolution on the approximate coefficient of a (j-1)-th scale and the high-pass filter and then down-sampling by two the convolution results, where i is a current sampling point in a window, the summing i means summing all sampling points in the current window (for example, if a frequency of 3.2kHZ is adopted and each window includes 8 sampling points, then $i$=1, 2, ..., 8), and n is a discretization degree of the wavelet function and $n \in Z$.

An energy value of the detail coefficient $d_j$ of the j-th layer discomposed signal may be represented as:

$$E_{d,j} = \sum_{n=1}^{N} d_j^2$$

$$(6),$$

then the sum of energy values of the five layers of high frequency detail coefficients is represented as

$$E_d = \sum_{j=1}^{5} E_{d,j} = \sum_{j=1}^{5} \sum_{n=1}^{N} d_j^2$$

$$(7).$$

Optionally, the indicator vector reference samples may be composed of indicator reference samples corresponding to five reasons of single-phase grounded incipient failure, putting a voltage transformer into operation, putting a capacitor into operation, a load inputting and an electric motor starting.

Optionally, the indicator reference samples corresponding to single-phase grounded incipient failure, putting the voltage transformer into operation, putting the capacitor into operation, the load inputting and the electric motor starting are established in the order of the indicators in $X_1$.

$$X_0 = \begin{bmatrix} X_{01} \\ X_{02} \\ \vdots \\ X_{05} \end{bmatrix} = \begin{bmatrix} x_{01}(1) & x_{01}(2) & \cdots & x_{01}(s) \\ x_{02}(2) & x_{02}(2) & \cdots & x_{02}(s) \\ \vdots & \vdots & \ddots & \vdots \\ x_{05}(1) & x_{05}(2) & \cdots & x_{05}(s) \end{bmatrix}$$ (8),

where $X_{0k}(k=1,2,...,5)$ is feature vectors of short-time single-phase overcurrent respectively caused by the above five reasons, of which the number of dimensions is the same as the number of dimensions of $X_1$; and $x_{0k}(1)$ to $x_{0k}(s)$ are indicators such as detail coefficients and approximate coefficients of the above short-time single-phase overcurrent in the electric cable, which are obtained from the measured data and empirical data.

Optionally, the association coefficients may be calculated for reasons one by one or may be calculated by using a matrix.

Optionally, in a case that the association coefficients are calculated by using a matrix, the calculation is performed as follows.

Association coefficients between a comparison sample $X_1$ and reference feature vectors $X_{0k}$ are calculated, and an association coefficient between the comparison sample $X_1$ and an $l$-th indicator ($l=1,2,...,s$) in the reference sequence $X_{0k}$ is represented as:

$$\xi_k^{(l)} = \frac{\min\limits_{\substack{1 \le l \le s \\ 1 \le k \le 5}} |x_1(l) - x_{0k}(l)| + \rho \max\limits_{\substack{1 \le l \le s \\ 1 \le k \le 5}} |x_1(l) - x_{0k}(l)|}{|x_1(l) - x_{0k}(l)| + \rho \max\limits_{\substack{1 \le l \le s \\ 1 \le k \le 5}} |x_1(l) - x_{0k}(l)|}$$ (9),

where $\rho$ represents a resolution ratio. An anti-interference capability of an association analysis can be improved by selecting a reasonable resolution ratio, and generally $\rho$=0.5.

Optionally, association degrees may be calculated for reasons one by one or may be calculated by using a matrix.

Optionally, in a case that the association degrees are calculated by using a matrix, the calculation is performed as follows.

An association degree $\gamma_k$ between the comparison sample $X_1$ and the reference sequence $X_{0k}$ may be obtained by combining the association coefficient matrix $\zeta$ and the weight vector $\omega_x$ of indicators,

$$\gamma_k = \sum_{l=1}^{s} \omega_x^{(l)} \xi_k^{(l)}$$ (10),

where $\omega_x^{(l)}$ is a weight coefficient of an $l$-th indicator. Since the weight coefficient $\omega_x^{(l)}$ and the association coefficient $\xi_k^{(l)}$ each are a value ranging from 0 to 1, the association degree $\gamma_k$ between the comparison sample $X_1$ and the reference sequences $X_{0k}$ is also in a range from 0 to 1. If $\gamma_k$=0, then $X_1$ and $X_{0k}$ are completely unrelated; or, if $\gamma_k$=1, then $X_1$=$X_{0k}$. The larger $\gamma_k$ is, the larger the association degree between $X_1$ and $X_{0k}$ is.

By finding a maximal $\gamma_k$, it is judged that the current short-time single-phase overcurrent is caused by a reason corresponding to k. Therefore, a short-time single-phase overcurrent caused by an incipient failure of the electric cable can be identified from multiple reasons for short-time single-phase overcurrent.

Based on the above technical solutions, in the method for identifying the reason for the overcurrent in the electric cable according to the embodiments of the present disclosure, a transient feature of an overcurrent can be analyzed in both time domain and frequency domain with a time-frequency domain method, a jump of a current signal can be detected effectively with a modulus maximum of a current signal after a wavelet transform is performed on the current signal, and a reconstruction is performed in time domain to acquire a duration of a jump in the time domain. An indicator feature vector is comprised of indicators obtained during a time-frequency analysis in which a wavelet transform is performed, the duration of the jump in the time domain and the modulus maximum of the current signal after the wavelet transform is performed on the current signal. The association coefficients between the indicator feature vector and indicators in reference sample vectors established based on reasons for the incipient failure of the electric cable are calculated, and the association degrees between the association coefficient matrix and predetermined indicator weight vector are calculated, hence, the association degrees are obtained. The present disclosure has advantages that the association degrees between the indicator feature vector and the reference sample vectors corresponding to the reasons are obtained after calculation. An item having a maximal association degree is found, hence, the reason for the overcurrent is found. Therefore, an accurate reason for the current single-phase overcurrent in the electric cable is determined, and it may also be determined which electric single-phase overcurrent is caused by the incipient failure of the electric cable, and thus the incipient failure of the electric cable can be identified accurately. In this case, a reasonable measure may be taken to restore or replace the electric cable, the number of serious failures can be reduced effectively, losses due to power failures caused by failures of power cables are reduced, a secure operation capability of an electric grid is improved and the service lives of lines of the electric grid are prolonged.

A reason for an overcurrent in an electric cable may be identified with the method for identifying the reason for the overcurrent in the electric cable according to the embodiments of the present disclosure.

Hereinafter, a device for identifying a reason for an overcurrent in an electric cable according to an embodiment of the present disclosure is described. And the following device for identifying the reason for the overcurrent in the electric cable may refer to the above method for identifying the reason for the overcurrent in the electric cable.

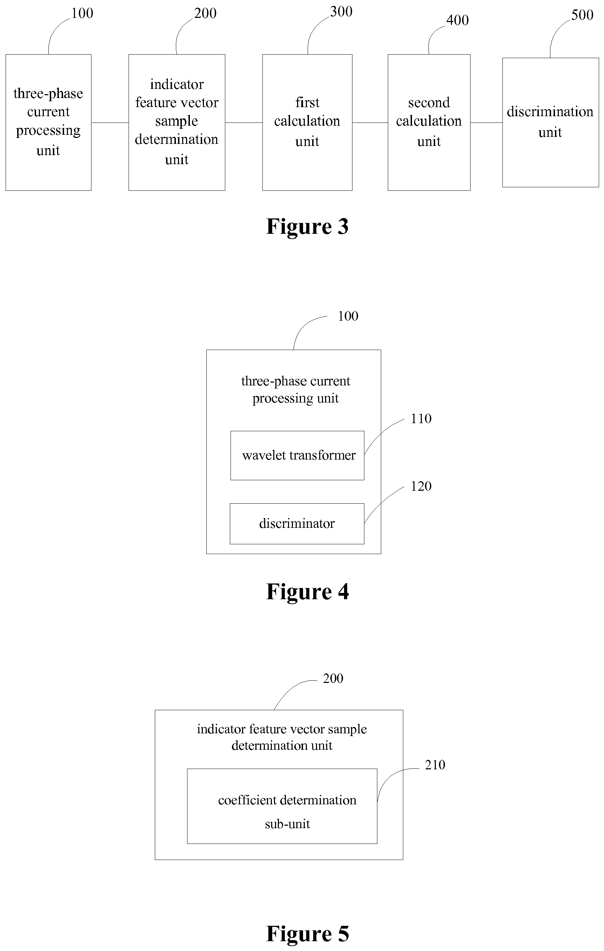

Figure 3 is a block diagram of a device for identifying a reason for an overcurrent in an electric cable according to an embodiment of the present disclosure. Referring to figure 3, the device for identifying the reason for the overcurrent in the electric cable may include:

a three-phase current processing unit 100, configured to detect whether a single-phase overcurrent occurs in three-phase current signals;

an indicator feature vector sample determination unit 200, configured to determine an indicator feature vector sample of an overcurrent phase current signal in a case that it is detected that the single-phase overcurrent occurs in the three-phase current signals;

a first calculation unit 300, configured to calculate association coefficients between the indicator feature vector sample and predetermined indicator vector reference samples of indicators, where the indicator vector reference samples respectively correspond to reasons for the single-phase overcurrent;

a second calculation unit 400, configure to calculate association degrees between the indicator feature vector sample and the predetermined indicator vector reference samples based on an indicator weight vector and the association coefficients corresponding to the indicators; and

a discrimination unit 500, configured to find a reason for the single-phase overcurrent reason corresponding to an indicator vector reference sample having a maximal association degree.

Optionally, Figure 4 shows a block diagram of the three-phase current processing unit 100 according to an embodiment of the present disclosure. The three-phase current processing unit 100 may include:

a wavelet transformer 110, configured to perform a wavelet transform on the three-phase current signals in the electric cable and calculate wavelet transform modulus maxima for the phase currents; and
a discriminator 120, configured to detect whether a wavelet transform modulus maximum of only one phase current jumps successively twice in a range from 0.5 cycles to 5 cycles, and determine that a short-time overcurrent occurs in the one phase current in a case that it is detected that the wavelet transform modulus maximum of the one phase current jumps successively twice in the range from 0.5 cycles to 5 cycles.

Figure 5 shows a block diagram of the indicator feature vector sample determination unit 200 according to the invention. The indicator feature vector sample determination unit 200 may include:
a coefficient determination sub-unit 210, configured to perform a wavelet transform on the three-phase current signals in the electric cable by using a db4 wavelet and perform a five-layer discomposing on the transformed three-phase current signals to obtain five layers of high-frequency detail coefficients, one layer of low-frequency approximate coefficient, the sum of energy values of the layers of detail coefficients, an effective value of the current phase current and a duration of the current, and determine the nine indicators as the indicator feature vector sample.

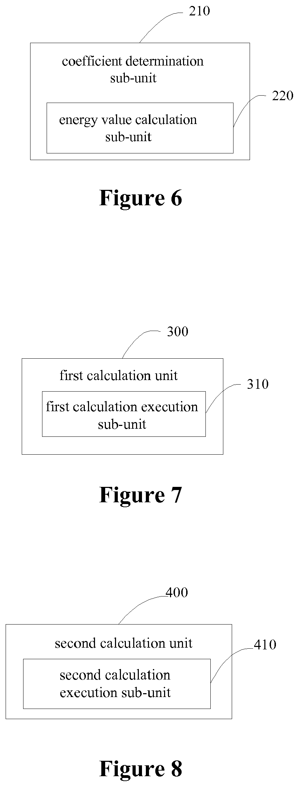

Optionally, Figure 6 shows a block diagram of the coefficient determination sub-unit 210 according to an embodiment of the present disclosure. The coefficient determination sub-unit 210 may include an energy value calculation sub-unit 220 configured to calculate the sum of the energy values of the layers of detail coefficients based on a formula of:

$$E_d = \sum_{j=1}^{5} \sum_{n=1}^{N} d_j^2$$

where $E_d$ is the sum of the energy values of the layers of detail coefficients, and $d_j$ is a detail coefficient of a j-th layer.

Optionally, Figure 7 shows a block diagram of the first calculation unit 300 according to an embodiment of the present disclosure. The first calculation unit 300 may include:

a first calculation execution sub-unit 310, configured to calculate association coefficients with the following formula of:

$$\xi_k^{(l)} = \frac{\min_{\substack{1 \le l \le s \\ 1 \le k \le 5}} |x_1(l) - x_{0k}(l)| + \rho \max_{\substack{1 \le l \le s \\ 1 \le k \le 5}} |x_1(l) - x_{0k}(l)|}{|x_1(l) - x_{0k}(l)| + \rho \max_{\substack{1 \le l \le s \\ 1 \le k \le 5}} |x_1(l) - x_{0k}(l)|},$$

where $\rho$ is a resolution ratio. An anti-interference capability of an association analysis can be improved by selecting a reasonable resolution ratio, and generally $\rho=0.5$.

Optionally, Figure 8 shows a block diagram of the second calculation unit 400 according to an embodiment of the present disclosure. The second calculation unit 400 may include:

a second calculation execution sub-unit 410, configured to calculate the association degrees based on a formula of:

$$\gamma_k = \sum_{l=1}^{s} \omega_x^{(l)} \xi_k^{(l)}$$

, where $\gamma_k$ is an association degree between the indicator feature vector sample and a $k$-th indicator vector reference sample, $\omega_x^{(l)}$ is a weight coefficient of an $l$-th indicator, $\xi_k^{(l)}$ is an association coefficient between the indicator feature vector sample and the $l$-th indicator of the $k$-th indicator vector reference sample, and s is the number of the indicators.

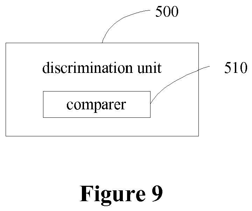

Optionally, Figure 9 shows a block diagram of the discrimination unit 500 according to an embodiment of the present disclosure. The discrimination unit 500 may include:

a comparer 510, configured to compare the association degrees to find an association degree having a maximal value, and to find an indicator vector reference sample corresponding to the maximal association degree. Therefore, a reason for a current single-phase overcurrent is found since the indicator vector reference samples respectively correspond to reasons for single-phase overcurrent.

A reason for an overcurrent in the electric cable may be identified by using the device for identifying the reason for the overcurrent in the electric cable according to the embodiment of the present disclosure.

The embodiments in the specification are described in a progressive way, each of which emphasizes the differences from others, and the same or similar parts among the embodiments can be referred to each other. Since the device disclosed in the embodiments corresponds to the method therein, the description thereof is relatively simple, and for relevant matters, references may be made to the description of the method.

It should be understood by those skilled in the art that, units and algorithm steps of examples described in conjunction with the embodiments disclosed herein can be implemented with electronic hardware, computer software or a combination thereof. In order to clearly illustrate the interchangeability between the hardware and software, components and steps of the examples are described based on functions in a general way in the above specification. Whether to implement these functions in a hardware manner or in a software manner depends on specified applications and design constraint conditions of the technical solution. Those skilled in the art may implement the described functions in a different way for each specified application, which should not be considered to beyond the scope of the present disclosure.

The steps of the exemplary methods or algorithms can be implemented with hardware, software modules executed by a processor, or a combination thereof. The software modules may reside in a Random Access Memory (RAM), an internal memory, a Read Only Memory (ROM), an Electrically Programmable ROM, an Electrically-Erasable Programmable ROM, a register, a hard disk, a removable disk drive, a CD-ROM, or other types of storage media well known in the field.

In the above, the method for identifying the reason for the overcurrent in the electric cable and the device for the same according to the embodiments of the present disclosure are described in detail. The principle and implementations of the present disclosure are set forth with specific examples herein, and the descriptions of the above embodiments are only for helping to understand the method and the core concept of the present disclosure.

**Claims**

1. A method for identifying a reason for an overcurrent in an electric cable, comprising:

   step 1), detecting whether a single-phase overcurrent occurs in three-phase current signals;
   step 2), determining an indicator feature vector sample of an overcurrent phase current signal in a case that it is detected that the single-phase overcurrent occurs in the three-phase current signals;
   step 3), calculating association coefficients between the indicator feature vector sample and predetermined indicator vector reference samples of indicators, wherein the indicator vector reference samples respectively correspond to reasons for the single-phase overcurrent;
   step 4), calculating association degrees between the indicator feature vector sample and the predetermined indicator vector reference samples based on a predetermined indicator weight vector and the association coefficients corresponding to the indicators; and
   step 5), finding a reason for the single-phase overcurrent, which corresponds to an indicator vector reference sample having a maximal association degree,

   **characterized in that**, the determining the indicator feature vector sample of the overcurrent phase current signal in the three-phase current signals in step 2) comprises: performing a wavelet transform on the three-phase current signals in the electric cable by using a db4 wavelet; performing a five-layer discomposing on the transformed three-phase current signals to obtain five layers of high-frequency detail coefficients, one layer of low-frequency approximate coefficient, the sum of energy values of the layers of detail coefficients, an effective value of the overcurrent phase current and a duration of the overcurrent; and determining thereby nine indicators as the indicator feature vector sample.

2. The method according to claim 1, wherein the detecting whether the single-phase overcurrent occurs in the three-phase current signals in step 1) comprises: performing a wavelet transform on the three-phase current signals in the electric cable; calculating wavelet transform modulus maxima for the phase currents; detecting whether a wavelet transform modulus maximum of only one phase current jumps successively twice in a range from 0.5 cycles to 5 cycles; and determining that a short-time overcurrent occurs in the one phase current in a case that it is detected that the wavelet transform modulus maximum of the only one phase current jumps successively twice in the range from 0.5 cycles to 5 cycles.

3. The method according to claim 1, wherein the sum of the energy values of the layers of detail coefficients is calculated by using a formula of: $E_d = \sum_{j=1}^{5} \sum_{n=1}^{N} d_j^2$, where $E_d$ is the sum of the energy values of the layers of detail coefficients, and $d_j$ is a detail coefficient of a j-th layer.

4. The method according to claim 1, wherein the association degrees in step 4) are calculated by using a formula of:

$$\gamma_k = \sum_{l=1}^{s} \omega_x^{(l)} \xi_k^{(l)},$$

where $\gamma_k$ is an association degree between the indicator feature vector sample and a *k*-th indicator vector reference sample, $\omega_x^{(l)}$ is a weight coefficient of an *l*-th indicator, $\xi_k^{(l)}$ is an association coefficient between the indicator feature vector sample and the *l*-th indicator in the *k*-th indicator vector reference sample, and s is the number of indicators.

5. A device for identifying a reason for an overcurrent in an electric cable, comprising:

   a three-phase current processing unit (100), configured to detect whether a single-phase overcurrent occurs in three-phase current signals;

an indicator feature vector sample determination unit (200), configured to determine an indicator feature vector sample of an overcurrent phase current signal in a case that it is detected that the single-phase overcurrent occurs in the three-phase current signals;

a first calculation unit (300), configured to calculate association coefficients between the indicator feature vector sample and predetermined indicator vector reference samples of indicators, wherein the indicator vector reference samples respectively correspond to reasons for the single-phase overcurrent;

a second calculation unit (400), configure to calculate association degrees between the indicator feature vector sample and the predetermined indicator vector reference samples based on an indicator weight vector and the association coefficients corresponding to the indicators; and

a discrimination unit (500), configured to find a reason for the single-phase overcurrent, which corresponds to an indicator vector reference sample having a maximal association degree,

**characterized in that**, the indicator feature vector sample determination unit (200) comprises:

a coefficient determination sub-unit (210), configured to perform a wavelet transform on the three-phase current signals in the electric cable by using a db4 wavelet and perform a five-layer discomposing on the transformed three-phase current signals to obtain five layers of high-frequency detail coefficients, one layer of low-frequency approximate coefficient, the sum of energy values of the layers of detail coefficients, an effective value of the overcurrent phase current and a duration of the overcurrent, and determine thereby nine indicators as the indicator feature vector sample.

6. The device for identifying the reason for the overcurrent in the electric cable according to claim 5, wherein the three-phase current processing unit (100) comprises a wavelet transformer (110) and a discriminator (120), wherein

the wavelet transformer (110) is configured to perform a wavelet transform on the three-phase current signals in the electric cable and calculate wavelet transform modulus maxima for the phase currents; and

the discriminator (120) is configured to detect whether a wavelet transform modulus maximum of only one phase current jumps successively twice in a range from 0.5 cycles to 5 cycles, and determine that a short-time overcurrent occurs in the one phase current in a case that it is detected that the wavelet transform modulus maximum of the one phase current jumps successively twice in the range from 0.5 cycles to 5 cycles.

7. The device for identifying the reason for the overcurrent in the electric cable according to claim 5, wherein the coefficient determination sub-unit (210) comprises:

an energy value calculation sub-unit (220), configured to calculate the sum of the energy values of the layers of detail coefficients based on a formula of: $E_d = \sum_{j=1}^{5} \sum_{n=1}^{N} d_j^2,$ where $E_d$ is the sum of the energy values of the layers of detail coefficients, and $d_j$ is a detail coefficient of a j-th layer.

8. The device for identifying the reason for the overcurrent in the electric cable according to claim 5, wherein the second calculation unit (400) comprises:

a second calculation execution sub-unit (410), configured to calculate the association degrees based on a formula of: $\gamma_k = \sum_{l=1}^{s} \omega_x^{(l)} \xi_k^{(l)},$ where $\gamma_k$ is an association degree between the indicator feature vector sample and a $k$-th indicator vector reference sample, $\omega_x^{(l)}$ is a weight coefficient of an $l$-th indicator, $\xi_k^{(l)}$ is an association coefficient between the indicator feature vector sample and the $l$-th indicator in the $k$-th indicator vector reference sample, and s is the number of the indicators.

**Patentansprüche**

1. Verfahren zur Identifikation eines Grundes für einen Überstrom in einem elektrischen Kabel, umfassend:

Schritt 1), ein Detektieren, ob ein einphasiger Überstrom in dreiphasigen Stromsignalen auftritt;

Schritt 2), ein Bestimmen eines Indikatormerkmalsvektorbeispiels eines Überstromphasensstromsignals in einem Fall, dass detektiert wird, dass der einphasige Überstrom in den dreiphasigen Stromsignalen auftritt;

Schritt 3), ein Berechnen von Zuordnungskoeffizienten zwischen dem Indikatormerkmalsvektorbeispiel und vorgegebenen Indikatorvektorreferenzbeispielen von Indikatoren, wobei die Indikatorvektorreferenzbeispiele jeweils Gründen für den einphasigen Überstrom entsprechen;

Schritt 4), ein Berechnen von Zuordnungsgraden zwischen dem Indikatormerkmalsvektorbeispiel und den vorgegebenen Indikatorvektorreferenzbeispielen basierend auf einem vorgegebenen Indikatorgewichtungsvektor und den den Indikatoren entsprechenden Zuordnungskoeffizienten; und

Schritt 5), ein Finden eines Grundes für den einphasigen Überstrom, welcher einem Indikatorvektorreferenzbeispiel mit einem maximalen Zuordnungsgrad entspricht,

**dadurch gekennzeichnet, dass** das Bestimmen des Indikatormerkmalsvektorbeispiels des Überstromphasenstromsignals in den dreiphasigen Stromsignalen in Schritt 2) umfasst: ein Ausführen einer Wavelet-Transformation an den dreiphasigen Stromsignalen im elektrischen Kabel durch Verwendung einer db4-Wavelet; ein Ausführen einer fünfschichtigen Zersetzung an den transformierten dreiphasigen Stromsignalen, um fünf Schichten hochfrequenter Detailkoeffizienten, eine Schicht niederfrequenter Näherungskoeffizienten, die Summe von Energiewerten der Schichten von Detailkoeffizienten, einen effektiven Wert des Überstromphasenstroms und eine Dauer des Überstroms zu erhalten; und dadurch ein Bestimmen von neun Indikatoren als das Indikatormerkmalsvektorbeispiel.

2. Verfahren nach Anspruch 1, wobei das Detektieren, ob der einphasige Überstrom in den dreiphasigen Stromsignalen auftritt, in Schritt 1) umfasst: ein Ausführen einer Wavelet-Transformation an den dreiphasigen Stromsignalen im elektrischen Kabel; ein Berechnen von Wavelet-Transformationsmodulusmaxima für die Phasenströme; ein Detektieren, ob ein Wavelet-Transformationsmodulusmaximum nur von einphasigem Strom aufeinanderfolgend zweimal in einem Bereich von 0,5 Zyklen bis 5 Zyklen springt; und ein Bestimmen, dass ein kurzzeitiger Überstrom in dem einphasigen Strom auftritt, in einem Fall, dass detektiert wird, dass das Wavelet-Transformationsmodulusmaximum nur von einphasigem Strom aufeinanderfolgend zweimal im Bereich von 0,5 Zyklen bis 5 Zyklen springt.

3. Verfahren nach Anspruch 1, wobei die Summe von Energiewerten der Schichten von Detailkoeffizienten mithilfe einer Formel: $E_d = \sum_{j=1}^{5} \sum_{n=1}^{N} d_j^2$ berechnet wird,

wobei $E_d$ die Summe der Energiewerte der Schichten von Detailkoeffizienten ist, und $d_j$ ein Detailkoeffizient einer j-ten Schicht ist.

4. Verfahren nach Anspruch 1, wobei die Zuordnungsgrade in Schritt 4) mithilfe einer Formel: $\gamma_k = \sum_{l=1}^{s} \omega_x^{(l)} \xi_k^{(l)}$

berechnet werden,

wobei $\gamma_k$ ein Zuordnungsgrad zwischen dem Indikatormerkmalsvektorbeispiel und einem k-ten Indikatorvektorreferenzbeispiel, $\omega_x^{(l)}$ ein Gewichtungskoeffizient eines l-ten Indikators, $\xi_k^{(l)}$ ein Zuordnungskoeffizient zwischen dem Indikatormerkmalsvektorbeispiel und dem l-ten Indikatorvektorreferenzbeispiel in dem k-ten Indikatorvektorreferenzbeispiel ist und s die Anzahl von Indikatoren ist.

5. Vorrichtung zur Identifikation eines Grundes für einen Überstrom in einem elektrischen Kabel, umfassend:

eine dreiphasige Stromverarbeitungseinheit (100), die konfiguriert ist, um zu detektieren, ob ein einphasiger Überstrom in dreiphasigen Stromsignalen auftritt;

eine Indikatormerkmalsvektorbeispielbestimmungseinheit (200), die konfiguriert ist, um ein Indikatormerkmalsvektorbeispiel eines Überstromphasensstromsignals in einem Fall zu bestimmen, dass detektiert wird, dass der einphasige Überstrom in den dreiphasigen Stromsignalen auftritt;

eine erste Berechnungseinheit (300), die konfiguriert ist, um Zuordnungskoeffizienten zwischen dem Indikatormerkmalsvektorbeispiel und vorgegebenen Indikatorvektorreferenzbeispielen von Indikatoren zu berechnen, wobei die Indikatorvektorreferenzbeispiele jeweils Gründen für den einphasigen Überstrom entsprechen;

eine zweite Berechnungseinheit (400), die konfiguriert ist, um Zuordnungsgrade zwischen dem Indikatormerkmalsvektorbeispiel und den vorgegebenen Indikatorvektorreferenzbeispielen basierend auf einem Indikatorgewichtungsvektor und den den Indikatoren entsprechenden Zuordnungskoeffizienten zu berechnen; und

eine Unterscheidungseinheit (500), die konfiguriert ist, um einen Grund für den einphasigen Überstrom zu finden, der einem Indikatorvektorreferenzbeispiel mit einem maximalen Zuordnungsgrad entspricht, **dadurch gekennzeichnet, dass** die Indikatormerkmalsvektorbeispielbestimmungseinheit (200) umfasst:

eine Koeffizientenbestimmungsuntereinheit (210), die konfiguriert ist, um eine Wavelet-Transformation an den dreiphasigen Stromsignalen im elektrischen Kabel durch Verwendung einer db4-Wavelet auszuführen und eine fünfschichtige Zersetzung an den transformierten dreiphasigen Stromsignalen auszuführen, um fünf Schichten hochfrequenter Detailkoeffizienten, eine Schicht niederfrequenter Näherungskoeffizienten, die Summe von Energiewerten der Schichten von Detailkoeffizienten, einen effektiven Wert des Überstromphasenstroms und eine Dauer des Überstroms zu erhalten; und dadurch neun Indikatoren als das Indikatormerkmalsvektorbeispiel zu bestimmen.

6. Vorrichtung zur Identifikation des Grundes für den Überstrom im elektrischen Kabel nach Anspruch 5, wobei die dreiphasige Stromverarbeitungseinheit (100) einen Wavelet-Transformator (110) und einen Unterscheider (120) umfasst, wobei
der Wavelet-Transformator (110) konfiguriert ist, um eine Wavelet-Transformation an den dreiphasigen Stromsignalen im elektrischen Kabel durchzuführen und Wavelet-Transformationsmodulusmaxima für Phasenströme zu berechnen; und
der Unterscheider (120) konfiguriert ist, um zu detektieren, ob ein Wavelet-Transformationsmodulusmaximum von nur einphasigem Strom aufeinanderfolgend zweimal in einem Bereich von 0,5 Zyklen bis 5 Zyklen springt, und zu bestimmen, dass ein kurzzeitiger Überstrom im einphasigen Strom in einem Fall auftritt, dass detektiert wird, dass das Wavelet-Transformationsmodulusmaximum des einphasigen Stroms aufeinanderfolgend zweimal im Bereich von 0,5 Zyklen bis 5 Zyklen springt.

7. Vorrichtung zur Identifikation des Grundes für den Überstrom im elektrischen Kabel nach Anspruch 5, wobei die Koeffizientenbestimmungsuntereinheit (210) umfasst:
eine Energiewertberechnungsuntereinheit (220), die konfiguriert ist, um die Summe der Energiewerte der Schichten von Detailkoeffizienten basierend auf einer Formel: $E_d = \sum_{j=1}^{5} \sum_{n=1}^{N} d_j^2$ zu berechnen,

wobei $E_d$ die Summe der Energiewerte der Schichten von Detailkoeffizienten ist, und $d_j$ ein Detailkoeffizient einer j-ten Schicht ist.

8. Vorrichtung zur Identifikation des Grundes für den Überstrom im elektrischen Kabel nach Anspruch 5, wobei die zweite Berechnungseinheit (400) umfasst:

eine zweite Berechnungsausführungsuntereinheit (410), die konfiguriert ist, um die Zuordnungsgrade basierend

auf einer Formel: $\gamma_k = \sum_{l=1}^{s} \omega_x^{(l)} \xi_k^{(l)}$ zu berechnen,

wobei $\gamma_k$ ein Zuordnungsgrad zwischen dem Indikatormerkmalsvektorbeispiel und einem k-ten Indikatorvektorreferenzbeispiel, $\omega_x^{(l)}$ ein Gewichtungskoeffizient eines l-ten Indikators, $\xi_k^{(l)}$ ein Zuordnungskoeffizient zwischen dem Indikatormerkmalsvektorbeispiel und dem l-ten Indikatorvektorreferenzbeispiel in dem k-ten Indikatorvektorreferenzbeispiel ist und s die Anzahl der Indikatoren ist.

**Revendications**

1. Procédé permettant l'identification d'une raison d'une surintensité dans un câble électrique, comprenant : l'étape 1), la détection pour savoir si une surintensité monophasée survient dans des signaux de courant triphasé ;

l'étape 2), la détermination d'un échantillon de vecteur de caractéristique d'indicateur d'un signal de courant de phase de surintensité dans le cas où la survenance de la surintensité monophasée dans les signaux de courant triphasé est détectée ;
l'étape 3), le calcul des coefficients d'association entre l'échantillon de vecteur de caractéristique d'indicateur et des échantillons de référence de vecteur d'indicateur prédéfinis d'indicateurs, lesdits échantillons de référence de vecteur d'indicateur correspondant respectivement aux raisons de la surintensité monophasée ;
l'étape 4), le calcul des degrés d'association entre l'échantillon de vecteur de caractéristique d'indicateur et les échantillons de référence de vecteur d'indicateur prédéfinis sur la base d'un vecteur de pondération d'indicateur prédéfini et des coefficients d'association correspondant aux d'indicateurs ; et

l'étape 5), la découverte d'une raison pour la surintensité monophasée, qui correspond à un échantillon de référence de vecteur d'indicateur possédant un degré d'association maximal, **caractérisé en ce que**, la détermination de l'échantillon de vecteur de caractéristique d'indicateur du signal de courant de phase de surintensité dans les signaux de courant triphasé à l'étape 2) comprend : la réalisation d'une transformée en ondelettes sur les signaux de courant triphasé dans le câble électrique à l'aide d'une ondelette db4 ; la réalisation d'une décomposition à cinq couches sur les signaux de courant triphasé transformés pour obtenir cinq couches de coefficients de détail haute fréquence, une couche de coefficient approximatif basse fréquence, la somme des valeurs d'énergie des couches de coefficients de détail, une valeur efficace du courant de phase de surintensité et une durée de la surintensité ; et ainsi la détermination de neuf indicateurs en tant qu'échantillon de vecteur de caractéristique d'indicateur.

2. Procédé selon la revendication 1, ladite détection pour savoir si la surintensité monophasée survient dans les signaux de courant triphasé à l'étape 1) comprenant : la réalisation d'une transformée en ondelettes sur les signaux de courant triphasé dans le câble électrique ; le calcul des maxima de module de transformation en ondelettes pour les courants de phase ; la détection pour savoir si un maximum de module de transformée en ondelettes d'un seul courant de phase saute successivement deux fois dans une plage allant de 0,5 cycle à 5 cycles ; et la détermination qu'une surintensité de courte durée survient dans le courant monophasé dans le cas où deux sauts successifs du maximum de module de transformée en ondelettes du seul courant monophasé dans la plage de 0,5 cycle à 5 cycles sont détectés.

3. Procédé selon la revendication 1, ladite somme des valeurs d'énergie des couches de coefficients de détail étant calculée à l'aide d'une formule de : $E_d = \sum_{j=1}^{5} \sum_{n=1}^{N} d_j^2$, où $E_d$ est la somme des valeurs d'énergie des couches de coefficients de détail, et $d_j$ est un coefficient de détail d'une j-ième couche.

4. Procédé selon la revendication 1, lesdits degrés d'association à l'étape 4) étant calculés à l'aide d'une formule de :

$$\gamma_k = \sum_{l=1}^{s} \omega_x^{(l)} \xi_k^{(l)},$$

où $\gamma_k$ est un degré d'association entre l'échantillon de vecteur de caractéristique d'indicateur et un k-ième échantillon de référence de vecteur d'indicateur, $\omega_x^{(l)}$ est un coefficient de pondération d'un l-ième indicateur, $\xi_k^{(l)}$ est un coefficient d'association entre l'échantillon de vecteur de caractéristique d'indicateur et le l-ième indicateur dans le k-ième échantillon de référence du vecteur d'indicateur, et $s$ est le nombre d'indicateurs.

5. Dispositif destiné à identifier une raison d'une surintensité dans un câble électrique, comprenant :

une unité de traitement de courant triphasé (100), conçue pour détecter si une surintensité monophasée survient dans les signaux de courant triphasé ;
une unité de détermination d'échantillon de vecteur de caractéristique d'indicateur (200), conçue pour déterminer un échantillon de vecteur de caractéristique d'indicateur d'un signal de courant de phase de surintensité dans le cas où la survenance de la surintensité monophasée dans les signaux de courant triphasé est détectée ;
une première unité de calcul (300), conçue pour calculer des coefficients d'association entre l'échantillon de vecteur de caractéristique d'indicateur et des échantillons de référence de vecteur d'indicateur prédéfinis d'indicateurs, lesdits échantillons de référence de vecteur d'indicateur correspondant respectivement aux raisons de la surintensité monophasée ;
une seconde unité de calcul (400), conçue pour calculer les degrés d'association entre l'échantillon de vecteur de caractéristique d'indicateur et les échantillons de référence de vecteur d'indicateur prédéfinis sur la base d'un vecteur de pondération d'indicateur et des coefficients d'association correspondant aux indicateurs ; et
une unité de discrimination (500), conçue pour trouver la raison de la surintensité monophasée, qui correspond à un échantillon de référence de vecteur d'indicateur possédant un degré d'association maximal, **caractérisé en ce que** l'unité de détermination d'échantillon de vecteur de caractéristique d'indicateur (200) comprend :
une sous-unité de détermination de coefficient (210), conçue pour effectuer une transformation en ondelettes sur les signaux de courant triphasé dans le câble électrique à l'aide d'une ondelette db4 et effectuer une décomposition en cinq couches sur les signaux de courant triphasé transformés pour obtenir cinq couches de coefficients de détail haute fréquence, une couche de coefficient approximatif basse fréquence, la somme des valeurs d'énergie des couches de coefficients de détail, une valeur efficace du courant de phase de surintensité et une durée de la surintensité, et déterminer ainsi neuf indicateurs en tant qu'échantillon de vecteur caractéristique d'indicateur.

**6.** Dispositif destiné à identifier la raison de la surintensité dans le câble électrique selon la revendication 5, ladite unité de traitement de courant triphasé (100) comprenant un transformateur en ondelettes (110) et un discriminateur (120), ledit transformateur en ondelettes (110) étant conçu pour effectuer une transformation en ondelettes sur les signaux de courant triphasé dans le câble électrique et pour calculer les maxima de module de transformée en ondelettes pour les courants de phase ; et

ledit discriminateur (120) étant conçu pour détecter si un maximum de module de transformée en ondelettes d'un seul courant de phase saute successivement deux fois dans une plage allant de 0,5 cycle à 5 cycles, et déterminer qu'une surintensité de courte durée survient dans le courant monophasé dans un cas où deux sauts successifs du maximum de module de transformée en ondelettes dans la plage allant de 0,5 cycle à 5 cycles sont détectés.

**7.** Dispositif destiné à identifier la raison de la surintensité dans le câble électrique selon la revendication 5, ladite sous-unité de détermination de coefficient (210) comprenant :

une sous-unité de calcul de valeur d'énergie (220), conçue pour calculer la somme des valeurs d'énergie des couches de coefficients de détail sur la base d'une formule de: $E_d = \sum_{j=1}^{5} \sum_{n=1}^{N} d_j^2$ , où $E_d$ est la somme des valeurs d'énergie des couches de coefficients de détail, et $d_j$ est un coefficient de détail d'une j-ième couche.

**8.** Dispositif destiné à identifier la raison de la surintensité dans le câble électrique selon la revendication 5, ladite seconde unité de calcul (400) comprenant :

une seconde sous-unité d'exécution de calcul (410), conçue pour calculer les degrés d'association sur la base d'une formule de: $\gamma_k = \sum_{l=1}^{s} \omega_x^{(l)} \xi_k^{(l)}$ ,

où $\gamma_k$ est un degré d'association entre l'échantillon de vecteur de caractéristique d'indicateur et un *k*-ième échantillon de référence de vecteur d'indicateur, $\omega_x^{(l)}$ est un coefficient de pondération d'un *l*-ième indicateur,

$\xi_k^{(l)}$ est un coefficient d'association entre l'échantillon de vecteur de caractéristique d'indicateur et le *l*-ième indicateur dans le *k*-ième échantillon de référence du vecteur d'indicateur, et *s* est le nombre d'indicateurs.

detect whether a single-phase overcurrent exists in three-phase current signals — s100

determine an indicator feature vector sample of an overcurrent phase current signal if it is detected that the single-phase overcurrent exists in the three-phase current signals — s110

calculate association coefficients between the indicator feature vector sample and indicators of predetermined indicator vector reference samples — s120

calculate association degrees between the indicator feature vector sample and the predetermined indicator vector reference samples based on a predetermined indicator weight vector and the association coefficients corresponding to the indicators — s130

find a reason for the single-phase overcurrent, which corresponds to an indicator vector reference sample having a maximal value of association degree — s140

**Figure 1**

S200

perform a wavelet transform on three-phase
current signals in the electric cable

S210

calculate wavelet transform modulus maxima
for the phase currents

S220

detect whether the wavelet transform modulus maxima
of the phase currents jump successively for two times
in a range from 0.5 cycles to 5 cycles

YES

NO

S230

determine that a short-time
overcurrent exists in the phase
current signal

S260

perform a wavelet transform
on three-phase current
signals in a next sampling
window

S240

judge whether the short-time
overcurrent only exists in the
phase current signal

NO

YES

S250

determine that the single-phase
overcurrent exists in the three-phase
current signals

**Figure 2**

**Figure 3**

**Figure 4**

**Figure 5**

210

coefficient determination
sub-unit

220

energy value calculation
sub-unit

## Figure 6

300

first calculation unit

310

first calculation execution
sub-unit

## Figure 7

400

second calculation unit

410

second calculation
execution sub-unit

## Figure 8

500

discrimination unit

510

comparer

**Figure 9**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201410383429
- CN 102721889

- CN 103713237

**Non-patent literature cited in the description**

- Fault Classification and Section Identification of an Advanced Series-Compensated Transmission Line Using Support Vector Machine. **DASH et al.** IEEE Transactions on Power Delivery. IEEE Service Center, 01 January 2007, vol. 22, 67-73

- Wavelet based transmission line fault analysis: A literature survey. **SUNDARAVARADAN et al.** 2014 14th International Conference on Environment and Electrical Engineering. IEEE, 10 May 2014, 254-259